# EUROPEAN PATENT APPLICATION

(11) **EP 4 462 807 A1**
(43) Date of publication of application: **13.11.2024**
(21) Application number: 23737019.2
(22) Date of filing: 04.01.2023
(51) Int. Cl.: H04R 1/10

(54) **WIRELESS EARPHONE CONTROL METHOD AND APPARATUS, AND ELECTRONIC DEVICE**

(30) Priority: 06.01.2022 CN 202210008385
(71) Applicant: VIVO MOBILE COMMUNICATION CO., LTD., Dongguan, Guangdong 523863 (CN)
(72) Inventor: PAN, Yong, Dongguan, Guangdong 523863 (CN)
(74) Representative: Lavoix
(86) International application number: PCT/CN2023/070312
(87) International publication number: WO 2023/131155

(57) **Abstract**

The present disclosure discloses a wireless earphone control method and apparatus and an electronic device, applied to a wireless earphone. The wireless earphone includes: a transceiver, an amplifier, a control switch, and an antenna, where a first end of the amplifier is electrically connected to the transceiver, a second end of the amplifier is electrically connected to the antenna, a bypass branch is provided between the first end and the second end of the amplifier, and the control switch is provided in the bypass branch. The method includes: obtaining a target parameter, where the target parameter includes a signal quality parameter of a target signal on the transceiver; in a case that the signal quality parameter is greater than a signal parameter threshold and a gain of the amplifier is greater than 0, reducing the gain of the amplifier; and in a case that the signal quality parameter is greater than the signal parameter threshold and the gain of the amplifier is equal to or less than 0, controlling the control switch to be in a conducted state so that the bypass branch is in a conducted state.

## Description

### CROSS-REFERENCE TO RELATED APPLICATIONS

This application claims priority to Chinese Patent Application No.202210008385.0, filed on January 6, 2022 and entitled "WIRELESS EARPHONE CONTROL METHOD, APPARATUS AND ELECTRONIC DEVICE", which is incorporated herein by reference in its entirety.

### TECHNICAL FIELD

The present disclosure pertains to the field of electronic technologies, and specifically relates to a wireless earphone control method and apparatus and an electronic device.

### BACKGROUND

With the development of electronic technologies, wireless earphones have been increasingly widely used in people's lives. However, during the process of implementing the present disclosure, the applicant has found that at least the following problem exists in the prior art: due to the small size of wireless earphones, the amount of power that can be stored is limited, and the power consumption is large, resulting in poor battery life of the wireless earphones.

### SUMMARY

The present disclosure aims to provide a wireless earphone control method and apparatus and an electronic device, so as to solve at least one of the problems of poor battery life of wireless earphones.

To solve the foregoing technical problem, the present disclosure is implemented as follows.

According to a first aspect, an embodiment of the present disclosure proposes a wireless earphone control method applied to a wireless earphone, and the wireless earphone includes: a transceiver, an amplifier, a control switch, and an antenna, where a first end of the amplifier is electrically connected to the transceiver, a second end of the amplifier is electrically connected to the antenna, a bypass branch is provided between the first end and the second end of the amplifier, and the control switch is provided in the bypass branch. The method includes:
obtaining a target parameter, where the target parameter includes a signal quality parameter of a target signal on the transceiver;
in a case that the signal quality parameter is greater than a signal parameter threshold and a gain of the amplifier is greater than 0, reducing the gain of the amplifier; and
in a case that the signal quality parameter is greater than the signal parameter threshold and the gain of the amplifier is equal to or less than 0, controlling the control switch to be in a conducted state so that the bypass branch is in a conducted state.

According to a second aspect, an embodiment of the present disclosure proposes a wireless earphone control apparatus applied to a wireless earphone, and the wireless earphone includes: a transceiver, an amplifier, a control switch, and an antenna, where a first end of the amplifier is electrically connected to the transceiver, a second end of the amplifier is electrically connected to the antenna, a bypass branch is provided between the first end and the second end of the amplifier, and the control switch is provided in the bypass branch; and
the wireless earphone control apparatus includes:
an obtaining module configured to obtain a target parameter, where the target parameter includes a signal quality parameter of a target signal on the transceiver;
a reducing module configured to, in a case that the signal quality parameter is greater than a signal parameter threshold and a gain of the amplifier is greater than 0, reduce the gain of the amplifier; and
a control module configured to, in a case that the signal quality parameter is greater than the signal parameter threshold and the gain of the amplifier is equal to or less than 0, control the control switch to be in a conducted state so that the bypass branch is in a conducted state.

According to a third aspect, an embodiment of the present disclosure provides an electronic device, where the electronic device includes a processor, a memory, and a program or instructions stored in the memory and capable of running on the processor, and when the program or instructions are executed by the processor, the steps of the method according to the first aspect are implemented.

According to a fourth aspect, an embodiment of the present disclosure provides a readable storage medium, where the readable storage medium stores a program or instructions, and when the program or instructions are executed by a processor, the steps of the method according to the first aspect are implemented.

According to a fifth aspect, an embodiment of the present disclosure provides a chip, where the chip includes a processor and a communication interface, the communication interface is coupled to the processor, and the processor is configured to run a program or instructions so as to implement the method according to the first aspect.

In the embodiments of the present disclosure, when the signal quality parameter of the wireless earphone is greater than the signal parameter threshold and the gain of the amplifier is greater than 0, the gain of the amplifier can be reduced. However, when the signal quality parameter is greater than the signal parameter threshold and the gain of the amplifier is equal to or less than 0, the control switch is controlled to be in a conducted state, so that the bypass branch is in a conducted state. In this case, the amplifier is equivalent to being short-circuited by the bypass branch, that is, the gain of the amplifier is reduced to 0. In this way, through the reduction of the gain of the amplifier, the power consumption and battery consumption of the wireless earphone can be reduced, thereby extending the use duration of the wireless earphone, that is, enhancing the battery life of the wireless earphone.

Additional aspects and advantages of the present disclosure will be given in part in the following description, part of which will become apparent from the following description or be learned from the practice of the present disclosure.

### BRIEF DESCRIPTION OF DRAWINGS

The above and/or additional aspects and advantages of the present disclosure will become obviously easy to understand from the description of the embodiments with reference to the following drawings.
FIG. 1 is a first flowchart of a wireless earphone control method according to an embodiment of the present disclosure;
FIG. 2 is a first schematic structural diagram of a wireless earphone according to an embodiment of the present disclosure;
FIG. 3 is a second flowchart of a wireless earphone control method according to an embodiment of the present disclosure;
FIG. 4 is a third flowchart of a wireless earphone control method according to an embodiment of the present disclosure;
FIG. 5 is a schematic structural diagram of a wireless earphone control apparatus according to an embodiment of the present disclosure;
FIG. 6 is a second schematic structural diagram of a wireless earphone according to an embodiment of the present disclosure; and
FIG. 7 is a schematic structural diagram of an electronic device according to an embodiment of the present disclosure.

### DETAILED DESCRIPTION OF EMBODIMENTS

Embodiments of the present disclosure are described in detail below. Examples of the embodiments are shown in the accompanying drawings, and reference signs that are always the same or similar indicate the same or similar components or components with the same or similar functions. The embodiments described below with reference to the drawings are illustrative and merely for explaining the present disclosure. They should not be construed as limitations on the present disclosure. All other embodiments obtained by persons of ordinary skill in the art based on the embodiments of the present disclosure without creative efforts shall fall within the protection scope of the present disclosure.

A feature modified by the term "first", "second", or the like in the specification and claims of the present disclosure can explicitly or implicitly include one or more such features. In descriptions of the present disclosure, unless otherwise specified, "plurality" means two or more. In addition, "and/or" in the specification and claims represents at least one of connected objects, and the character "/" generally indicates that the associated objects have an "or" relationship.

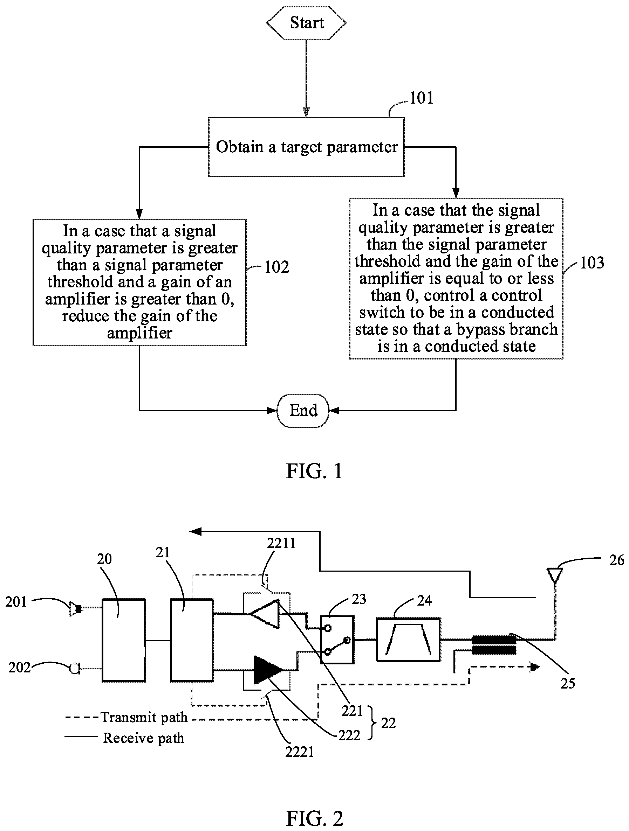

Referring to FIG. 1, FIG. 1 is a flowchart of a wireless earphone control method according to an embodiment of the present disclosure. The method is applied to a wireless earphone. FIG. 2 is a structural diagram of the wireless earphone, and the wireless earphone includes: a transceiver, an amplifier, a control switch, and an antenna, where a first end of the amplifier is electrically connected to the transceiver, a second end of the amplifier is electrically connected to the antenna, a bypass branch is provided between the first end and the second end of the amplifier, and the control switch is provided in the bypass branch.

As shown in FIG. 1, the method includes the following steps.

Step 101: Obtain a target parameter, where the target parameter includes a signal quality parameter of a target signal on the transceiver.

A type of the target signal is not limited herein, and the target signal may include at least one of a received signal and a transmitted signal. In one of the embodiments, the target signal is a received signal. When the signal quality parameter of the target signal is greater than a signal parameter threshold, it indicates that the target signal meets a minimum requirement for signal reception. In this case, a gain of the amplifier can be reduced to reduce the power consumption of the amplifier. Similarly, when the target signal is a transmitted signal, reference may be made to the foregoing relevant description regarding the target signal being a received signal, and the same beneficial effects can be achieved.

The specific type of the signal quality parameter is not limited herein. For example, the signal quality parameter may be signal-to-noise ratio or bit error rate. Correspondingly, a numerical value of a signal parameter threshold corresponding to a signal quality parameter varies with the type of the signal quality parameter. In other words, there may be a one-to-one correspondence between signal quality parameters and signal parameter thresholds. For signal parameter thresholds, reference may be made to specific description below.

In one of the embodiments, the method further includes:
determining a working scenario of the wireless earphone; and
determining the signal parameter threshold based on the working scenario.

The signal parameter threshold varies with the working scenario of the wireless earphone. For example, when the working scenario of the wireless earphone is a voice call scenario, it is only necessary to ensure that both parties can hear the spoken content clearly. Therefore, a relatively low signal parameter threshold is determined. When the working scenario of the wireless earphone is a music play scenario, the requirement for signal quality is high. Not only the lyrics, but also the accompaniment sounds of various instruments in the background music need to be heard clearly. Therefore, a relatively high signal parameter threshold is determined.

It should be noted that the method of determining the working scenario is not limited herein. For example, the working scenario may be determined based on the type of content being played. When the content being played is audio, the working scenario can be determined as an audio play scenario. When the content being played is video, the working scenario can be determined as a video play scenario. When the content being played is real-time voice received from another electronic device, the working scenario can be determined as a voice call scenario.

In this embodiment of the present disclosure, the signal parameter threshold is determined based on the working scenario, such that the signal parameter threshold can be determined more flexible and intelligent. Moreover, determining the signal parameter threshold based on the working scenario makes the determined signal parameter threshold better meet the requirements of the current working scenario, so that subsequent adjustment of the amplifier gain can better meet the requirements of the current working scenario. This not only meets the requirements of the working scenarios, but also reduces the power consumption of the wireless earphone.

It should be noted that any target parameter in the embodiments of the present disclosure may refer to a parameter of a part of a circuit of the wireless earphone, and the part of the circuit may include an amplifier. In other words, the target parameter may be understood as a parameter of the part of the circuit including the amplifier.

It should be noted that the foregoing wireless earphone typically comes in pairs. When the two earphones are both in working mode, the battery levels of the two earphones can be monitored. If the battery level of a target earphone falls below a preset threshold, a prompt signal may be output to remind the user to charge the target earphone. However, the other earphone than the target earphone in the two earphones can still work normally. This ensures that the two earphones can be used interchangeably (that is, used alternately to extend the battery life of the two earphones), significantly increasing the continuous usage time of the earphones for the user.

Step 102: In a case that the signal quality parameter is greater than a signal parameter threshold and a gain of the amplifier is greater than 0, reduce the gain of the amplifier.

The signal parameter threshold may be understood as a minimum value of the signal quality parameter required for the amplifier to implement its function. When the signal quality parameter is greater than the signal parameter threshold, it indicates that there is an adjustment margin in the signal quality parameter of the amplifier, and the gain of the amplifier can be reduced, so that the signal quality parameter of the wireless earphone is reduced. In this way, the power consumption and battery consumption of the amplifier can be reduced, thereby prolonging the use duration of the wireless earphone, that is, enhancing the battery life of the wireless earphone.

It should be noted that when the gain of the amplifier increases, the signal quality parameter of the wireless earphone also increases. Correspondingly, when the gain of the amplifier decreases, the signal quality parameter of the wireless earphone also decreases. In other words, the gain of the amplifier is positively correlated with the signal quality parameter of the wireless earphone. The signal quality parameter of the wireless earphone can be adjusted by adjusting the gain of the amplifier.

In one of the embodiments, the in a case that the signal quality parameter is greater than a signal parameter threshold and a gain of the amplifier is greater than 0, reducing the gain of the amplifier includes:
in a case that the signal quality parameter is greater than the signal parameter threshold and the gain of the amplifier is greater than 0, reducing the gain of the amplifier to a target gain, where the target gain is greater than 0.

The gain of the amplifier may include multiple levels of gain, and the multiple levels of gain may increase or decrease successively, with each level of gain corresponding to a different signal quality parameter. The gain of the amplifier before adjustment may be referred to as the current gain, and reducing the gain of the amplifier to the target gain may refer to reducing the gain of the amplifier from the current gain to the target gain. The adjustment method may be adjusting the current gain down by one or more levels, and finally obtained a gain as the target gain.

It should be noted that the signal quality parameter corresponding to the target gain is greater than the signal parameter threshold. In this way, the amplifier after adjustment can still meet the minimum requirements for implementing the functionality of the wireless earphone, ensuring that the functionality of the wireless earphones can be implemented normally.

In this embodiment of the present disclosure, when the gain of the amplifier is reduced to the target gain, the power consumption of the wireless earphone can be reduced, thereby extending the use duration of the wireless earphone that is, enhancing the battery life of the wireless earphone. In addition, because the target gain is greater than 0, the gain of the target signal can be adjusted through the amplifier, thereby enhancing the performance of the target signal.

Step 103: In a case that the signal quality parameter is greater than the signal parameter threshold and the gain of the amplifier is equal to or less than 0, control the control switch to be in a conducted state so that the bypass branch is in a conducted state.

The amplifier and the control switch may be considered to be connected in parallel. When the gain of the amplifier is equal to or less than 0, the amplifier is turned off. In this case, the gain of the amplifier is 0, that is, in this case, the signal directly passes through the bypass branch formed by the first end of the amplifier, the control switch, and the second end of the amplifier. The state of the amplifier in this case may be referred to as a Bypass (bypass) mode or Bypass state.

In this embodiment of the present disclosure, the gain of the amplifier is set to 0 by turning off the amplifier. This can also reduce the power consumption of the wireless earphone, thereby extending the use duration of the wireless earphone, that is, enhancing the battery life of the wireless earphone.

It should be noted that as shown in FIG. 2, the wireless earphone may further include a speaker 201, a microphone 202, an audio codec 20, a target controller 23, a filter 24, and a coupler 25, where the audio codec 20 is connected to both the speaker 201 and the microphone 202, the audio codec 20 is also electrically connected to the transceiver 21, the transceiver 21 is connected to the amplifier 22, and the amplifier 22 is electrically connected to an antenna 26 through the target controller 23, the filter 24, and the coupler 25 in sequence. The transceiver 21 is related to the type of the wireless earphone. When the wireless earphone is a Bluetooth earphone, the transceiver 21 may also be referred to as Bluetooth transceiver.

It should be noted that the amplifier 22 may be a bidirectional amplifier, that is, the amplifier 22 may have functions of both a receive amplifier 221 and a transmit amplifier 222. For example, two circuits may be provided inside the amplifier: one circuit is configured for amplifying received signals and the other circuit is configured for amplifying transmitted signals. Alternatively, the amplifier may include two amplifiers: one is configured for amplifying received signals and the other is configured for amplifying transmitted signals. Furthermore, the amplifier may also perform received signal amplification and transmitted signal amplification in different time periods, so that only one amplifier needs to be provided, reducing the overall size of the wireless earphone.

The target controller 23 is structurally adapted to the amplifier. When the amplifier includes only one circuit, the target controller 23 may be a single-control switch; and when the amplifier includes two circuits, the target controller 23 may be a single-pole double-throw switch, thus implementing switching between modes of transmitting signals and receiving signals.

The filter 24 is configured to filter out interference signals in the transmitted and received signals, the coupler 25 is mainly configured to measure the output power to implement power control, the antenna is configured to transmit and receive radio frequency signals, and the Bluetooth transceiver is mainly configured to modulate, demodulate, and process relevant transmitted and received signals. The audio codec 20 is configured to encode and decode audio signals, mainly configured to decode the digital signals provided by the Bluetooth transceiver to output analog audio to the speaker 201, and encode the analog audio signals received by the microphone 202 into digital signals for modulation, processing, and transmission by the Bluetooth transceiver.

In one of the embodiments, as shown in FIG. 2, the amplifier 22 includes a receive amplifier 221 and a transmit amplifier 222, and the control switch includes a first control switch 2211 and a second control switch 2221, where a first end of the receive amplifier 221 is electrically connected to the transceiver, a second end of the receive amplifier 221 is electrically connected to the antenna, a first bypass branch is provided between the first end and the second end of the receive amplifier 221, the first control switch 2211 is provided in the first bypass branch, a first end of the transmit amplifier 222 is electrically connected to the transceiver, a second end of the transmit amplifier 222 is electrically connected to the antenna, a second bypass branch is provided between the first end and the second end of the transmit amplifier 222, and the second control switch 2221 is provided in the second bypass branch.

The receive amplifier 221 may be referred to as a low noise amplifier (LNA), and the transmit amplifier 222 may be referred to as a power amplifier (PA). The PA may also be referred to as a radio frequency power amplifier.

The first control switch 2211 and the second control switch 2221 may be controlled by control ends on the Bluetooth transceiver respectively, where the control ends may be general-purpose input/output (GPIO) 1 and GPIO 2. In this way, the first control switch 2211 and the second control switch 2221 can be controlled through the Bluetooth transceiver, with no need to provide a separate controller, thereby reducing the size of the wireless earphone. This can also ensure that the signals received or transmitted by the Bluetooth transceiver are synchronous with the control signals for the first control switch 2211 and the second control switch 2221 in time, thus making the control results of the first control switch 2211 and the second control switch 2221 more accurate.

In this embodiment of the present disclosure, when both the receive amplifier 221 and the transmit amplifier 222 are provided, the receive amplifier 221 can amplify received signals, and the transmit amplifier 222 can amplify transmitted signals. This ensures good amplification effects for both received and transmitted signals, avoiding the phenomenon of signal confusion caused by confusion of the two kinds of signals.

In addition, a second control switch 2221 is connected in parallel to the transmit amplifier 222, and a first control switch 2211 is connected in parallel to the receive amplifier 221. Through the second control switch 2221 and the first control switch 2211, the transmit amplifier 222 and the receive amplifier 221 can be respectively placed in Bypass mode, so that the transmit amplifier 222 and the receive amplifier 221 are turned off, leaving the gains of the transmit amplifier 222 and the receive amplifier 221 at 0. This can reduce the power consumption of the wireless earphone, thereby extending the use duration of the wireless earphone, that is, enhancing the battery life of the wireless earphone.

It should be noted that a wireless earphone usually needs to connect wirelessly to an electronic device to play the content on the electronic device. Therefore, on the premise of ensuring the playing quality of the content being played, one idea is to perform adjustment according to the foregoing embodiments. Another idea is: in a case that the signal quality of the wireless earphone is less than or equal to the signal parameter threshold, reducing the gain of the amplifier on the wireless earphone may affect the signal quality, resulting in failure in implementing the normal functions of the wireless earphone; thus in this case, the signal quality can be enhanced by tuning up the gain of the electronic device connected to the wireless earphone.

For example, in an embodiment, when the amplifier includes the transmit amplifier, the target parameter further includes: a current gain and a maximum gain of an electronic device wirelessly connected to the wireless earphone, and the method further includes:
in a case that the signal quality parameter is less than or equal to the signal parameter threshold and the current gain of the electronic device is equal to the maximum gain of the electronic device, controlling the current gain of the electronic device to be maintained at the maximum gain; and
in a case that the signal quality parameter is less than or equal to the signal parameter threshold and the current gain of the electronic device is less than the maximum gain of the electronic device, tuning up the current gain of the electronic device.

The way in which the wireless earphone controls the electronic device to adjust the gain is not limited herein. For example, the wireless earphone transmits a first message to the electronic device, where the first message is used to control the current gain of the electronic device to be maintained at the maximum gain; or the wireless earphone transmits a second message to the electronic device, where the second message is used to tune up the current gain of the electronic device.

It should be noted that the maximum value to which the current gain of the electronic device can be tuned up to can only be equal to the maximum gain.

In this embodiment of the present disclosure, when the signal quality parameter is less than or equal to the signal parameter threshold, it is determined whether the current gain of the electronic device is less than the maximum gain. If the current gain is less than the maximum gain, it indicates that there is still room for increasing the gain of the electronic device, so the gain of the electronic device can be increased to the maximum gain, and the gain of the wireless earphone can also be reduced. This not only ensures the signal quality, but also reduces the power consumption of the wireless earphone. If the current gain is equal to the maximum gain, it indicates that adjusting the gain of the electronic device cannot improve the signal quality. In this case, the current gain of the electronic device can be maintained at the maximum gain to ensure that the signal quality does not decrease.

In the foregoing embodiment, the signal may refer to the signal transmitted from the electronic device to the wireless earphone for playing by the wireless earphone, and this signal, after transmitted to the wireless earphone, will also be transmitted between various components within the wireless earphone.

In an embodiment, when the amplifier includes the receive amplifier, the target parameter further includes: a current transmit power and a maximum transmit power of an electronic device wirelessly connected to the wireless earphone, and the method further includes:
in a case that the signal quality parameter is less than or equal to the signal parameter threshold and a first difference is less than a second difference, increasing a gain of the receive amplifier, and controlling the electronic device to maintain the current transmit power; and
in a case that the signal quality parameter is less than or equal to the signal parameter threshold and the first difference is greater than or equal to the second difference, increasing a transmit power of the electronic device; and
the first difference is a difference between the maximum transmit power and the current transmit power, and the second difference is a difference between the signal quality parameter and the signal parameter threshold.

In this embodiment of the present disclosure, through comparing the values of the first difference and the second difference, it can be determined whether compensation for the difference (that is, the second difference) between the signal quality parameter and the signal parameter threshold can be made by increasing the transmit power of the electronic device. In a case that the first difference is greater than the second difference, compensation for the second difference can be made by increasing the transmit power of the electronic device. In a case that the first difference is less than the second difference, compensation for the second difference cannot be made by increasing the transmit power of the electronic device. In this case, the electronic device needs to maintain the current transmit power, and the gain of the receive amplifier of the wireless earphone needs to be increased, so as to ensure the signal quality.

It should be noted that the specific manner of increasing the transmit power of the electronic device is not limited herein. For example, the transmit power of the electronic device may be increased level by level, that is, the transmit power of the electronic device is divided into multiple levels, and in the case of adjusting the transmit power of the electronic device, the current transmit power may be adjusted upward by one or more levels. Alternatively, the transmit power of the electronic device can be controlled to increase by a preset value each time it is increased. Alternatively, the transmit power of the electronic device may be directly controlled to increase to a target value (the target value may be the maximum transmit power, where the maximum transmit power may also be referred to as the maximum transmit capability).

In an embodiment, the target parameter further includes a reserved parameter, and the in a case that the signal quality parameter is less than or equal to the signal parameter threshold and the first difference is greater than or equal to the second difference, increasing a transmit power of the electronic device includes:
in a case that the signal quality parameter is less than or equal to the signal parameter threshold and the first difference is greater than or equal to the second difference, determining whether a sum of the current transmit power, the reserved parameter, and the second difference is greater than or equal to the maximum transmit power; and
in a case that the sum of the current transmit power, the reserved parameter, and the second difference is greater than or equal to the maximum transmit power, increasing the transmit power of the electronic device to a value corresponding to the sum of the current transmit power, the reserved parameter, and the second difference; or
in a case that the sum of the current transmit power, the reserved parameter, and the second difference is less than the maximum transmit power, increasing the transmit power of the electronic device to the maximum transmit power.

The reserved parameter may be referred to as a Pstep dB margin. Through determination of whether the sum of the current transmit power, reserved parameter, and second difference is greater than or equal to the maximum transmit power, it can be determined whether compensation for the second difference can be made while the Pstep dB margin is reserved.

In this embodiment, when the sum of the foregoing current transmit power, reserved parameter, and second difference is greater than or equal to the maximum transmit power, it indicates that the transmit power of the electronic device can be increased to the sum of the current transmit power, reserved parameter, and second difference with a reserved Pstep dB margin. This can decrease the number of iterations of adjustment of the power and the gain of the receive amplifier.

When the sum of the current transmit power, reserved parameter, and second difference is less than the maximum transmit power, it indicates that a critical value has been reached, that is, the transmit power of the electronic device cannot be increased with a reserved Pstep dB margin. In this case, the transmit power of the electronic device can be directly increased to the maximum transmit power.

In this embodiment of the present disclosure, through steps 101 to 103, when the signal quality parameter of the wireless earphone is greater than the signal parameter threshold and the gain of the amplifier is greater than 0, the gain of the amplifier can be reduced. However, when the signal quality parameter is greater than the signal parameter threshold and the gain of the amplifier is equal to or less than 0, the control switch is controlled to be in a conducted state, so that the bypass branch is in a conducted state. In this case, the amplifier is equivalent to being short-circuited by the bypass branch, that is, the gain of the amplifier is reduced to 0. In this way, the power consumption and battery consumption of the wireless earphone can be reduced by reducing the gain of the amplifier, thereby extending the use duration of the wireless earphone, that is, enhancing the battery life of the wireless earphone.

In the embodiments of the present disclosure, the electronic device may be a mobile phone, a tablet personal computer, a laptop computer, a personal digital assistant (PDA), a mobile internet device (MID), a wearable device, or the like.

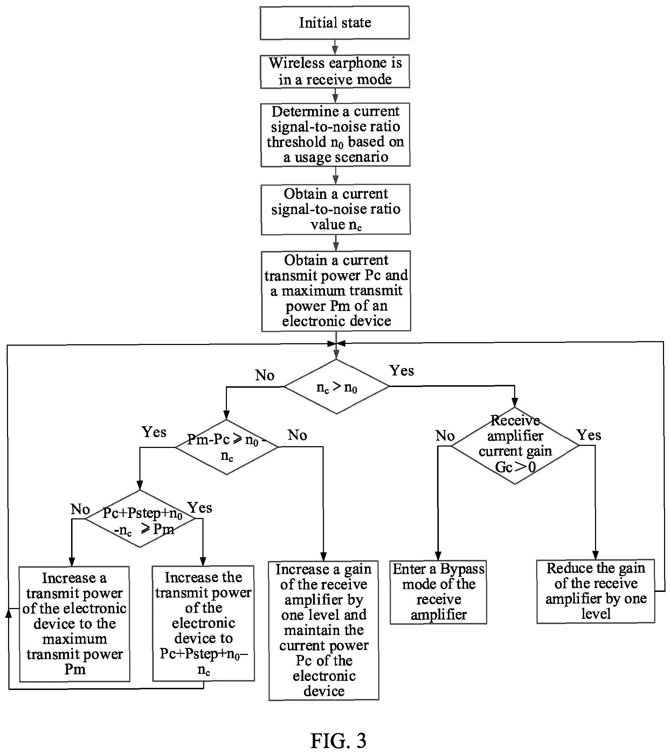

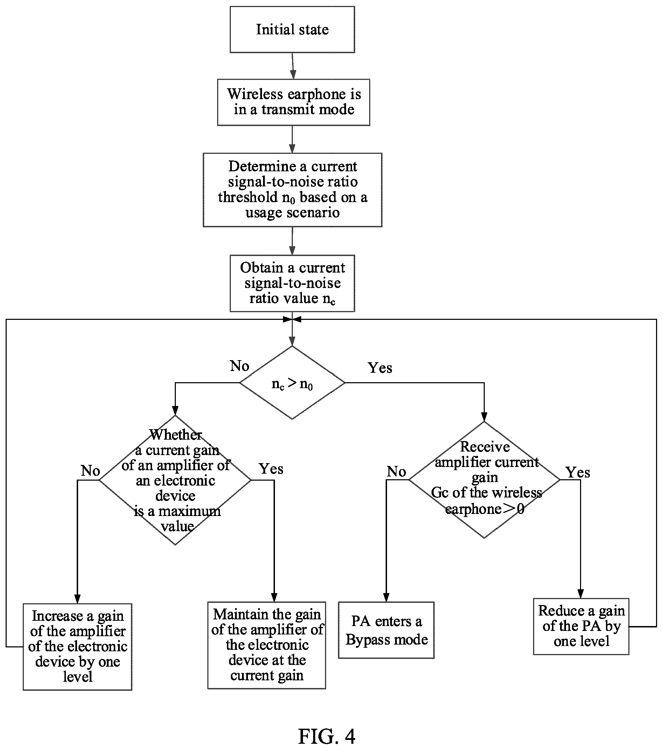

In order to better describe the foregoing embodiments, the following uses examples to describe the foregoing embodiments. For details, refer to steps shown in FIG. 3 and FIG. 4. In order to better represent the various features in the foregoing embodiments, the current transmit power in the foregoing embodiments may be referred to as Pc, the maximum transmit power may be referred to as Pm, the signal quality parameter may be referred to as n_{c}, the signal parameter threshold may be referred to as no, and the gain of the amplifier may be referred to as Gc.

It should be noted that the wireless earphone control method provided in the embodiment of the present disclosure may be performed by a wireless earphone control apparatus or a control module for performing the wireless earphone control method in the wireless earphone control apparatus. In the embodiments of the present disclosure, the wireless earphone control apparatus provided in this embodiment of the present disclosure is described by using an example in which a wireless earphone control apparatus performs the wireless earphone control method.

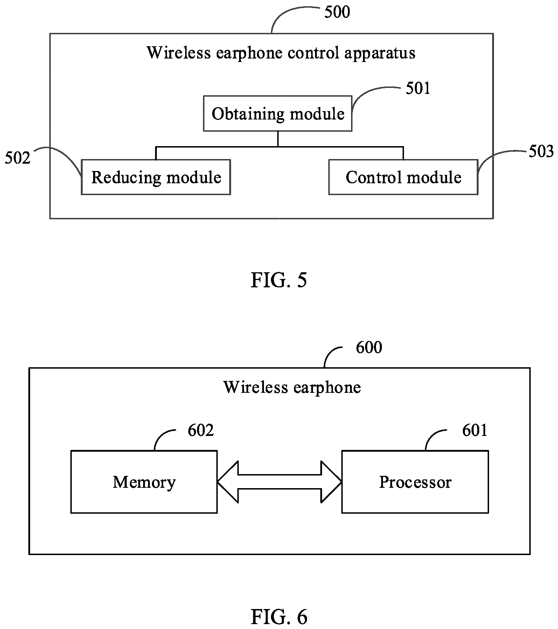

Referring to FIG. 5, FIG. 5 is a structural diagram of a wireless earphone control apparatus according to an embodiment of the present disclosure. The wireless earphone control apparatus is applied to a wireless earphone, where the wireless earphone includes: a transceiver, an amplifier, a control switch, and an antenna; where a first end of the amplifier is electrically connected to the transceiver, a second end of the amplifier is electrically connected to the antenna, a bypass branch is provided between the first end and the second end of the amplifier, and the control switch is provided in the bypass branch.

As shown in FIG. 5, the wireless earphone control apparatus 500 includes:
an obtaining module 501 configured to obtain a target parameter, where the target parameter includes a signal quality parameter of a target signal on the transceiver;
a reducing module 502 configured to, in a case that the signal quality parameter is greater than a signal parameter threshold and a gain of the amplifier is greater than 0, reduce the gain of the amplifier; and
a control module 503 configured to, in a case that the signal quality parameter is greater than the signal parameter threshold and the gain of the amplifier is equal to or less than 0, control the control switch to be in a conducted state so that the bypass branch is in a conducted state.

The reducing module 502 is further configured to, in a case that the signal quality parameter is greater than the signal parameter threshold and the gain of the amplifier is greater than 0, reduce the gain of the amplifier to a target gain, where the target gain is greater than 0.

The wireless earphone control apparatus 500 further includes:
a first determining module configured to determine a working scenario of the wireless earphone; and
a second determining module configured to determine the signal parameter threshold based on the working scenario, where different working scenarios correspond to different signal parameter thresholds.

The amplifier includes a receive amplifier and a transmit amplifier, and the control switch includes a first control switch and a second control switch, where a first end of the receive amplifier is electrically connected to the transceiver, a second end of the receive amplifier is electrically connected to the antenna, a first bypass branch is provided between the first end and the second end of the receive amplifier, and the first control switch is provided in the first bypass branch; and a first end of the transmit amplifier is electrically connected to the transceiver, a second end of the transmit amplifier is electrically connected to the antenna, a second bypass branch is provided between the first end and the second end of the transmit amplifier, and the second control switch is provided in the second bypass branch.

If the amplifier includes the transmit amplifier, the target parameter further includes: a current gain and a maximum gain of an electronic device wirelessly connected to the wireless earphone, and the wireless earphone control apparatus 500 further includes:
a maintaining module configured to, in a case that the signal quality parameter is less than or equal to the signal parameter threshold and the current gain of the electronic device is equal to the maximum gain of the electronic device, control the current gain of the electronic device to be maintained at the maximum gain; and
a tune-up module configured to, in a case that the signal quality parameter is less than or equal to the signal parameter threshold and the current gain of the electronic device is less than the maximum gain of the electronic device, tune up the current gain of the electronic device.

If the amplifier includes the receive amplifier, the target parameter further includes: a current transmit power and a maximum transmit power of an electronic device wirelessly connected to the wireless earphone, and the wireless earphone control apparatus 500 further includes:
a first increasing module configured to, in a case that the signal quality parameter is less than or equal to the signal parameter threshold and a first difference is less than a second difference, increase a gain of the receive amplifier, and control the electronic device to maintain the current transmit power; and
a second increasing module configured to, in a case that the signal quality parameter is less than or equal to the signal parameter threshold and the first difference is greater than or equal to the second difference, increase a transmit power of the electronic device; where
the first difference is a difference between the maximum transmit power and the current transmit power, and the second difference is a difference between the signal quality parameter and the signal parameter threshold.

The target parameter further includes: a reserved parameter, and the second increasing module includes:
a determining sub-module configured to, in a case that the signal quality parameter is less than or equal to the signal parameter threshold and the first difference is greater than or equal to the second difference, determine whether a sum of the current transmit power, the reserved parameter, and the second difference is greater than or equal to the maximum transmit power;
a first increasing sub-module configured to, in a case that the sum of the current transmit power, the reserved parameter, and the second difference is greater than or equal to the maximum transmit power, increase the transmit power of the electronic device to a value corresponding to the sum of the current transmit power, the reserved parameter, and the second difference; and
a second increasing sub-module configured to, in a case that the sum of the current transmit power, the reserved parameter and the second difference is less than the maximum transmit power, increase the transmit power of the electronic device to the maximum transmit power.

The wireless earphone control apparatus in this embodiment of the present disclosure may be an electronic device, or may be a component in an electronic device, such as an integrated circuit or a chip. The electronic device may be a terminal or other devices than terminals. For example, the electronic device may be a mobile phone, a tablet computer, a notebook computer, a palmtop computer, a vehicle-mounted electronic device, a mobile Internet device (MID), an augmented reality (AR)/virtual reality (VR) device, a robot, a wearable device, an ultra-mobile personal computer (UMPC), a netbook, or a personal digital assistant (PDA), and may also be a server, a network attached storage (NAS), a personal computer (PC), a television (TV), a teller machine, a self-service machine, or the like. This is not specifically limited in the embodiments of the present disclosure.

The wireless earphone control apparatus in this embodiment of the present disclosure may be an apparatus with an operating system. The operating system may be an Android operating system, an iOS operating system, or another possible operating system. This is not specifically limited in an embodiment of the present disclosure.

The wireless earphone control apparatus provided in this embodiment of the present disclosure can implement the processes implemented in the method embodiments in FIG. 1, FIG. 3, and FIG. 4. To avoid repetition, details are not described herein again.

Referring to FIG. 6, an embodiment of the present disclosure further provides a wireless earphone 600 including a processor 601, a memory 602, and a program or instructions stored in the memory 602 and capable of running on the processor 601. When the program or instructions are executed by the processor 601, the processes of the foregoing embodiment of the wireless earphone control method are implemented, with the same technical effects achieved. To avoid repetition, details are not described herein again.

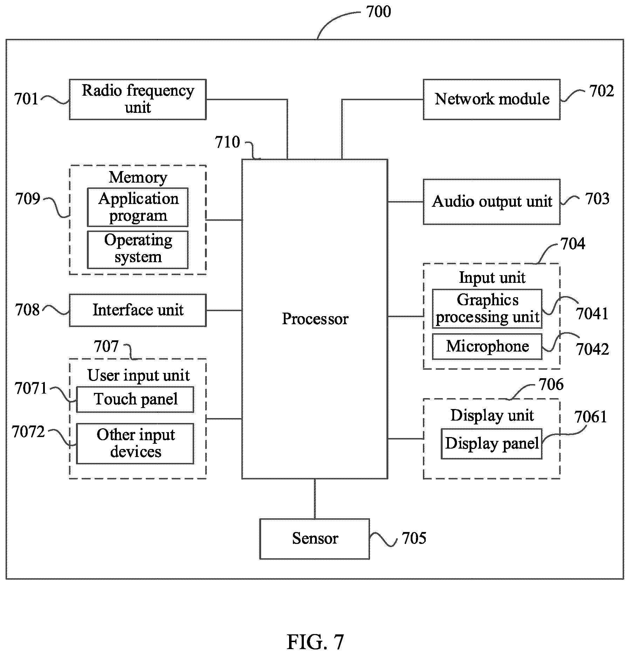

FIG. 7 is a schematic diagram of a hardware structure of an electronic device according to an embodiment of the present disclosure.

The electronic device 700 includes but is not limited to components such as a radio frequency unit 701, a network module 702, an audio output unit 703, an input unit 704, a sensor 705, a display unit 706, a user input unit 707, an interface unit 708, a memory 709, and a processor 710. The electronic device 700 may be the wireless earphone in the foregoing embodiments. The wireless earphone includes: a transceiver, an amplifier, a control switch, and an antenna; where a first end of the amplifier is electrically connected to the transceiver, a second end of the amplifier is electrically connected to the antenna, a bypass branch is provided between the first end and the second end of the amplifier, and the control switch is provided in the bypass branch.

Those skilled in the art can understand that the electronic device 700 may further include a power supply (for example, a battery) that supplies power to various components. The power supply may be logically connected to the processor 710 through a power management system, so that functions such as charge and discharge management and power consumption management are implemented by using the power management system. The structure of the electronic device shown in FIG. 7 does not constitute a limitation on the electronic device. The electronic device may include more or fewer components than those shown in the figure, or some components may be combined, or there may be a different component layout. Details are not described herein again.

The processor 710 is configured to:
obtain a target parameter, where the target parameter includes a signal quality parameter of a target signal on the transceiver;
in a case that the signal quality parameter is greater than a signal parameter threshold and a gain of the amplifier is greater than 0, reduce the gain of the amplifier; and
in a case that the signal quality parameter is greater than the signal parameter threshold and the gain of the amplifier is equal to or less than 0, control the control switch to be in a conducted state so that the bypass branch is in a conducted state.

The step of in a case that the signal quality parameter is greater than a signal parameter threshold and a gain of the amplifier is greater than 0, reducing the gain of the amplifier performed by the processor 710 includes:
in a case that the signal quality parameter is greater than the signal parameter threshold and the gain of the amplifier is greater than 0, reducing the gain of the amplifier to a target gain, where the target gain is greater than 0.

The processor 710 is further configured to:
determine a working scenario of the wireless earphone; and
determine the signal parameter threshold based on the working scenario, where different working scenarios correspond to different signal parameter thresholds.

The amplifier includes a receive amplifier and a transmit amplifier, and the control switch includes a first control switch and a second control switch, where a first end of the receive amplifier is electrically connected to the transceiver, a second end of the receive amplifier is electrically connected to the antenna, a first bypass branch is provided between the first end and the second end of the receive amplifier, and the first control switch is provided in the first bypass branch; and a first end of the transmit amplifier is electrically connected to the transceiver, a second end of the transmit amplifier is electrically connected to the antenna, a second bypass branch is provided between the first end and the second end of the transmit amplifier, and the second control switch is provided in the second bypass branch.

If the amplifier includes the transmit amplifier, the target parameter further includes: a current gain and a maximum gain of an electronic device wirelessly connected to the wireless earphone, and the processor 710 is further configured to:
in a case that the signal quality parameter is less than or equal to the signal parameter threshold and the current gain of the electronic device is equal to the maximum gain of the electronic device, control the current gain of the electronic device to be maintained at the maximum gain; and
in a case that the signal quality parameter is less than or equal to the signal parameter threshold and the current gain of the electronic device is less than the maximum gain of the electronic device, tune up the current gain of the electronic device.

If the amplifier includes the receive amplifier, the target parameter further includes: a current transmit power and a maximum transmit power of an electronic device wirelessly connected to the wireless earphone, and the processor 710 is further configured to:
in a case that the signal quality parameter is less than or equal to the signal parameter threshold and a first difference is less than a second difference, increase a gain of the receive amplifier, and control the electronic device to maintain the current transmit power; and
in a case that the signal quality parameter is less than or equal to the signal parameter threshold and the first difference is greater than or equal to the second difference, increase a transmit power of the electronic device; where
the first difference is a difference between the maximum transmit power and the current transmit power, and the second difference is a difference between the signal quality parameter and the signal parameter threshold.

The target parameter further includes a reserved parameter, and the in a case that the signal quality parameter is less than or equal to the signal parameter threshold and the first difference is greater than or equal to the second difference, increasing a transmit power of the electronic device performed by the processor 710 includes:
in a case that the signal quality parameter is less than or equal to the signal parameter threshold and the first difference is greater than or equal to the second difference, determining whether a sum of the current transmit power, the reserved parameter, and the second difference is greater than or equal to the maximum transmit power; and
in a case that the sum of the current transmit power, the reserved parameter, and the second difference is greater than or equal to the maximum transmit power, increasing the transmit power of the electronic device to a value corresponding to the sum of the current transmit power, the reserved parameter, and the second difference; or
in a case that the sum of the current transmit power, the reserved parameter, and the second difference is less than the maximum transmit power, increasing the transmit power of the electronic device to the maximum transmit power.

This embodiment of the present disclosure can also have the same beneficial technical effects as the foregoing embodiments, and the details are not described herein again.

It should be understood that in an embodiment of the present disclosure, the input unit 704 may include a graphics processing unit (GPU) 7041 and a microphone 7042. The graphics processing unit 7041 processes image data of a static picture or a video obtained by an image capture apparatus (such as a camera) in a video capture mode or an image capture mode. The display unit 706 may include a display panel 7061. The display panel 7061 may be configured in a form of a liquid crystal display, an organic light-emitting diode display, or the like. The user input unit 707 includes a touch panel 7071 and other input devices 7072. The touch panel 7071 is also referred to as a touchscreen. The touch panel 7071 may include two parts: a touch detection apparatus and a touch controller. Specifically, the other input devices 7072 may include but are not limited to a physical keyboard, a function button (for example, a volume control button or an on/off button), a trackball, a mouse, and a joystick. Details are not described herein. The memory 709 may be configured to store software programs and various data which include but are not limited to an application program and an operating system. The processor 710 may integrate an application processor and a modem processor. The application processor mainly processes an operating system, a user interface, an application program, and the like. The modem processor mainly processes wireless communication. It can be understood that the modem processor may alternatively be not integrated in the processor 710.

An embodiment of the present disclosure further provides a readable storage medium. The readable storage medium stores a program or instructions, and when the program or instructions are executed by a processor, the processes of the foregoing wireless earphone control method embodiments are implemented, with the same technical effects achieved. To avoid repetition, details are not described herein again.

The processor is the processor in the electronic device in the foregoing embodiments. The readable storage medium includes a computer-readable storage medium, for example, a computer read-only memory (ROM), a random access memory (RAM), a magnetic disk, or an optical disc.

An embodiment of the present disclosure further provides a chip. The chip includes a processor and a communication interface, the communication interface is coupled to the processor, and the processor is configured to run a program or instructions to implement the processes of the foregoing wireless earphone control method embodiments, with the same technical effects achieved. To avoid repetition, details are not described herein again.

It should be understood that the chip mentioned in an embodiment of the present disclosure may also be referred to as a system-level chip, a system chip, a chip system, a system-on-chip, or the like.

It should be noted that in this specification, the terms "include" and "comprise", or any of their variants are intended to cover a non-exclusive inclusion, such that a process, method, article, or apparatus that includes a list of elements not only includes those elements but also includes other elements that are not expressly listed, or further includes elements inherent to such process, method, article, or apparatus. In absence of more constraints, an element preceded by "includes a..." does not preclude the existence of other identical elements in the process, method, article, or apparatus that includes the element. Furthermore, it should be noted that the scope of the method and apparatus in the embodiments of the present disclosure is not limited to performing the functions in the order shown or discussed, but may also include performing the functions in a substantially simultaneous manner or in a reverse order depending on the functions involved. For example, the described method may be performed in an order different from the order described, and steps may be added, omitted, or combined. In addition, features described with reference to some examples may be combined in other examples.

Based on the above description of embodiments, persons skilled in the art can clearly understand that the method in the foregoing embodiments can be implemented through software on a necessary hardware platform or certainly through hardware only, but in many cases, the former is the more preferred implementation. Based on such an understanding, the technical solutions of the present disclosure essentially, or the part contributing to the prior art may be implemented in a form of a software product. The computer software product is stored in a storage medium (for example, a ROM/RAM, a magnetic disk, or an optical disc), and includes several instructions for instructing a terminal (which may be a mobile phone, a computer, a server, an air conditioner, a network device, or the like) to perform the method described in the embodiments of the present disclosure.

The foregoing describes the embodiments of the present disclosure with reference to the accompanying drawings. However, the present disclosure is not limited to the foregoing specific embodiments. The foregoing specific embodiments are merely illustrative rather than restrictive. As instructed by the present disclosure, persons of ordinary skill in the art may develop many other manners without departing from principles of the present disclosure and the protection scope of the claims, and all such manners fall within the protection scope of the present disclosure.

## Claims

1. A wireless earphone control method applied to a wireless earphone, wherein the wireless earphone comprises: a transceiver, an amplifier, a control switch, and an antenna; wherein a first end of the amplifier is electrically connected to the transceiver, a second end of the amplifier is electrically connected to the antenna, a bypass branch is provided between the first end and the second end of the amplifier, and the control switch is provided in the bypass branch; and the method comprises:
obtaining a target parameter, wherein the target parameter comprises a signal quality parameter of a target signal on the transceiver;
in a case that the signal quality parameter is greater than a signal parameter threshold and a gain of the amplifier is greater than 0, reducing the gain of the amplifier; and
in a case that the signal quality parameter is greater than the signal parameter threshold and the gain of the amplifier is equal to or less than 0, controlling the control switch to be in a conducted state so that the bypass branch is in a conducted state.

2. The method according to claim 1, wherein the in a case that the signal quality parameter is greater than a signal parameter threshold and a gain of the amplifier is greater than 0, reducing the gain of the amplifier comprises:
in a case that the signal quality parameter is greater than the signal parameter threshold and the gain of the amplifier is greater than 0, reducing the gain of the amplifier to a target gain, wherein the target gain is greater than 0.

3. The method according to claim 1, wherein the method further comprises:
determining a working scenario of the wireless earphone; and
determining the signal parameter threshold based on the working scenario, wherein different working scenarios correspond to different signal parameter thresholds.

4. The method according to claim 1, wherein the amplifier comprises a receive amplifier and a transmit amplifier, and the control switch comprises a first control switch and a second control switch, wherein a first end of the receive amplifier is electrically connected to the transceiver, a second end of the receive amplifier is electrically connected to the antenna, a first bypass branch is provided between the first end and the second end of the receive amplifier, and the first control switch is provided in the first bypass branch; and a first end of the transmit amplifier is electrically connected to the transceiver, a second end of the transmit amplifier is electrically connected to the antenna, a second bypass branch is provided between the first end and the second end of the transmit amplifier, and the second control switch is provided in the second bypass branch.

5. The method according to claim 4, wherein when the amplifier comprises the transmit amplifier, the target parameter further comprises: a current gain and a maximum gain of an electronic device wirelessly connected to the wireless earphone, and the method further comprises:
in a case that the signal quality parameter is less than or equal to the signal parameter threshold and the current gain of the electronic device is equal to the maximum gain of the electronic device, controlling the current gain of the electronic device to be maintained at the maximum gain; and
in a case that the signal quality parameter is less than or equal to the signal parameter threshold and the current gain of the electronic device is less than the maximum gain of the electronic device, tuning up the current gain of the electronic device.

6. The method according to claim 4, wherein when the amplifier comprises the receive amplifier, the target parameter further comprises: a current transmit power and a maximum transmit power of an electronic device wirelessly connected to the wireless earphone, and the method further comprises:
in a case that the signal quality parameter is less than or equal to the signal parameter threshold and a first difference is less than a second difference, increasing a gain of the receive amplifier, and controlling the electronic device to maintain the current transmit power; and
in a case that the signal quality parameter is less than or equal to the signal parameter threshold and the first difference is greater than or equal to the second difference, increasing a transmit power of the electronic device; wherein
the first difference is a difference between the maximum transmit power and the current transmit power, and the second difference is a difference between the signal quality parameter and the signal parameter threshold.

7. The method according to claim 6, wherein the target parameter further comprises a reserved parameter, and the in a case that the signal quality parameter is less than or equal to the signal parameter threshold and the first difference is greater than or equal to the second difference, increasing a transmit power of the electronic device comprises:
in a case that the signal quality parameter is less than or equal to the signal parameter threshold and the first difference is greater than or equal to the second difference, determining whether a sum of the current transmit power, the reserved parameter, and the second difference is greater than or equal to the maximum transmit power; and
in a case that the sum of the current transmit power, the reserved parameter, and the second difference is greater than or equal to the maximum transmit power, increasing the transmit power of the electronic device to a value corresponding to the sum of the current transmit power, the reserved parameter, and the second difference; or
in a case that the sum of the current transmit power, the reserved parameter, and the second difference is less than the maximum transmit power, increasing the transmit power of the electronic device to the maximum transmit power.

8. A wireless earphone control apparatus applied to a wireless earphone, wherein the wireless earphone comprises: a transceiver, an amplifier, a control switch, and an antenna; wherein a first end of the amplifier is electrically connected to the transceiver, a second end of the amplifier is electrically connected to the antenna, a bypass branch is provided between the first end and the second end of the amplifier, and the control switch is provided in the bypass branch; and
the wireless earphone control apparatus comprises:
an obtaining module configured to obtain a target parameter, wherein the target parameter comprises a signal quality parameter of a target signal on the transceiver;
a reducing module configured to, in a case that the signal quality parameter is greater than a signal parameter threshold and a gain of the amplifier is greater than 0, reduce the gain of the amplifier; and
a control module configured to, in a case that the signal quality parameter is greater than the signal parameter threshold and the gain of the amplifier is equal to or less than 0, control the control switch to be in a conducted state so that the bypass branch is in a conducted state.

9. The wireless earphone control apparatus according to claim 8, wherein the reducing module is further configured to, in a case that the signal quality parameter is greater than the signal parameter threshold and the gain of the amplifier is greater than 0, reduce the gain of the amplifier to a target gain, wherein the target gain is greater than 0.

10. The wireless earphone control apparatus according to claim 8, wherein the wireless earphone control apparatus further comprises:
a first determining module configured to determine a working scenario of the wireless earphone; and
a second determining module configured to determine the signal parameter threshold based on the working scenario, wherein different working scenarios correspond to different signal parameter thresholds.

11. The wireless earphone control apparatus according to claim 8, wherein the amplifier comprises a receive amplifier and a transmit amplifier, and the control switch comprises a first control switch and a second control switch, wherein a first end of the receive amplifier is electrically connected to the transceiver, a second end of the receive amplifier is electrically connected to the antenna, a first bypass branch is provided between the first end and the second end of the receive amplifier, and the first control switch is provided in the first bypass branch; and a first end of the transmit amplifier is electrically connected to the transceiver, a second end of the transmit amplifier is electrically connected to the antenna, a second bypass branch is provided between the first end and the second end of the transmit amplifier, and the second control switch is provided in the second bypass branch.

12. The wireless earphone control apparatus according to claim 11, wherein when the amplifier comprises the transmit amplifier, the target parameter further comprises: a current gain and a maximum gain of an electronic device wirelessly connected to the wireless earphone, and the wireless earphone control apparatus further comprises:
a maintaining module configured to, in a case that the signal quality parameter is less than or equal to the signal parameter threshold and the current gain of the electronic device is equal to the maximum gain of the electronic device, control the current gain of the electronic device to be maintained at the maximum gain; and
a tune-up module configured to, in a case that the signal quality parameter is less than or equal to the signal parameter threshold and the current gain of the electronic device is less than the maximum gain of the electronic device, tune up the current gain of the electronic device.

13. The wireless earphone control apparatus according to claim 11, wherein when the amplifier comprises the receive amplifier, the target parameter further comprises: a current transmit power and a maximum transmit power of an electronic device wirelessly connected to the wireless earphone, and the wireless earphone control apparatus further comprises:
a first increasing module configured to, in a case that the signal quality parameter is less than or equal to the signal parameter threshold and a first difference is less than a second difference, increase a gain of the receive amplifier, and control the electronic device to maintain the current transmit power; and
a second increasing module configured to, in a case that the signal quality parameter is less than or equal to the signal parameter threshold and the first difference is greater than or equal to the second difference, increase a transmit power of the electronic device; wherein
the first difference is a difference between the maximum transmit power and the current transmit power, and the second difference is a difference between the signal quality parameter and the signal parameter threshold.

14. The wireless earphone control apparatus according to claim 13, wherein the target parameter further comprises: a reserved parameter, and the second increasing module comprises:
a determining sub-module configured to, in a case that the signal quality parameter is less than or equal to the signal parameter threshold and the first difference is greater than or equal to the second difference, determine whether a sum of the current transmit power, the reserved parameter, and the second difference is greater than or equal to the maximum transmit power;
a first increasing sub-module configured to, in a case that the sum of the current transmit power, the reserved parameter, and the second difference is greater than or equal to the maximum transmit power, increase the transmit power of the electronic device to a value corresponding to the sum of the current transmit power, the reserved parameter, and the second difference; and
a second increasing sub-module configured to, in a case that the sum of the current transmit power, the reserved parameter, and the second difference is less than the maximum transmit power, increase the transmit power of the electronic device to the maximum transmit power.

15. An electronic device, comprising a processor, a memory, and a program or instructions stored in the memory and capable of running on the processor, wherein when the program or instructions are executed by the processor, the steps of the wireless earphone control method according to any one of claims 1 to 7 are implemented.

16. A readable storage medium, wherein the readable storage medium stores a program or instructions, and when the program or instructions are executed by a processor, the steps of the wireless earphone control method according to any one of claims 1 to 7 are implemented.

17. A chip, wherein the chip comprises a processor and a communication interface, wherein the communication interface is coupled to the processor, and the processor is configured to run a program or instructions to implement the wireless earphone control method according to any one of claims 1 to 7.

18. A computer program product, wherein the program product is stored in a non-transient storage medium, and the program product is executed by at least one processor so as to implement the wireless earphone control method according to any one of claims 1 to 7.

19. A wireless earphone control apparatus, wherein the wireless earphone control apparatus is configured to perform the wireless earphone control method according to any one of claims 1 to 7.
